# EUROPEAN PATENT SPECIFICATION

(11) **EP 3 416 185 B1**
(45) Date of publication and mention of the grant of the patent: **15.09.2021**
(21) Application number: 16889804.7
(22) Date of filing: 10.02.2016
(51) Int. Cl.: H01L 21/67, H05K 13/02

(54) **HOLDING PLATE, DETECTION METHOD, AND DIE SUPPLY DEVICE**
HALTEPLATTE, DETEKTIONSVERFAHREN UND CHIPZUFÜHRVORRICHTUNG
PLAQUE DE SUPPORT, PROCÉDÉ DE DÉTECTION, ET DISPOSITIF DE FOURNITURE DE PUCE

(43) Date of publication of application: 19.12.2018
(73) Proprietor: Fuji Corporation, Chiryu-shi, Aichi 472-8686 (JP)
(72) Inventor: MURAI, Masaki, Chiryu, Aichi, (JP); ITO, Toshiya, Chiryu, Aichi, (JP); YAMASAKI, Toshihiko, Chiryu, Aichi, (JP)
(74) Representative: Grünecker Patent- und Rechtsanwälte PartG mbB
(86) International application number: PCT/JP2016/053903
(87) International publication number: WO 2017/138102

(56) References cited:
- JP-A- H 065 690
- JP-A- H02 114 547
- JP-A- H08 139 114
- JP-A- 2003 086 612
- JP-A- 2003 086 612
- JP-A- 2006 281 502
- JP-A- 2013 004 895
- JP-A- 2013 247 314
- JP-U- S57 179 907

## Description

### Technical Field

The present invention relates to a system comprising a die supply device and a holding plate as well as to a detecting method for detecting a push amount of a pushing tool.

### Background Art

A die body is formed by adhering a wafer to a dicing sheet and then performing dicing. When supplying a die from the die body, a die is supplied in a state peeled from the dicing sheet by pushing the die from below using a pushing tool. Here, for example, if a die push amount is insufficient, the die may not be appropriately peeled from the dicing sheet. Therefore, it is desired to appropriately adjust the push amount by a pushing tool, and to this end technology has been developed for detecting a push amount of a pushing tool, such as that disclosed in the below patent literature.

Patent literature 1: JP-A-2013-247314
JP 08-139114

### Summary of Invention

### Technical Problem

According to the above patent literature, it is possible to a certain extent to detect a push amount of a pushing tool, but it is desired to even more suitably detect a push amount of a pushing tool. The present invention takes account of such circumstances, and an object thereof is to suitably detect a push amount of a pushing tool.

### Solution to Problem

A system according to claim 1 and a method according to claim 5 are disclosed.

### Advantageous Effects

The system of the present invention includes a detecting tool for detecting the push amount of a pushing tool, and is held by a holding stage for holding a die body. Accordingly, it is possible to detect the push amount of the pushing tool at the position at which the die is actually pushed, thus it is possible to detect the push amount accurately.

Also, with the detection method of the present invention, the holding plate is configured from a main body plate in which a through-hole is formed, and a biasing plate that covers the through-hole and is arranged in a state biased towards the main body plate by an elastic force, and the detecting tool is arranged on the biasing plate. Further, the push amount of the pushing tool is detected by the detecting tool in a state in which the contacting section of the pushing device is contacting the biasing plate of the holding plate held by the holding stage. Therefore, for example, even if the holding plate held by the holding stage and the pushing tool are not in a straight line, due to contact by the contacting section, the biasing plate is raised against the elastic force and the biasing plate and the pushing tool are made to be in a straight line. Accordingly, it is possible to appropriately detect the push amount of the pushing tool.

Also, the die body and the holding plate are housed in a housing section, and either one of the die body or the holding stage is pulled out from the housing section to a position above the holding stage by operation of a pulling out device. Then, in a case in which the die body is held by the holding stage, a die is supplied in a state being pushed by the pushing tool, and in a case in which the holding plate is held by the holding stage, the push amount of the pushing tool is detected by the detecting tool. Accordingly, it is possible to detect the push amount of the pushing tool automatically.

### Brief Description of Drawings

- Fig. 1: is a perspective view of an electronic component mounter.
- Fig. 2: is a plan view of an electronic component mounter.
- Fig. 3: is a perspective view of a die supply device.
- Fig. 4: is a cross section showing a die pushing unit.
- Fig. 5: is a block diagram showing a control device.
- Fig. 6: is a perspective view showing a measurement plate.
- Fig. 7: is a perspective view showing a dial indicator.

### Description of Preferred Embodiments

The following describes in detail referring to the figures an example embodiment of the present invention.

### Configuration of electronic component mounter.

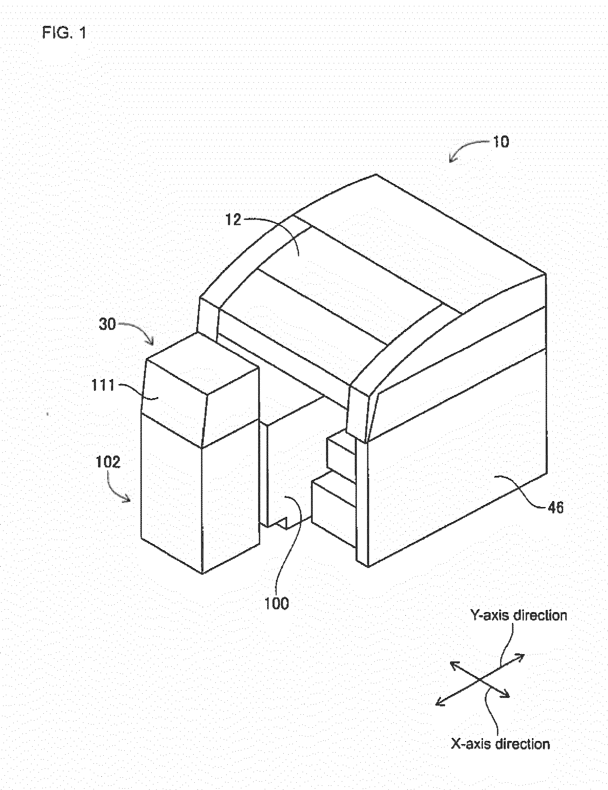

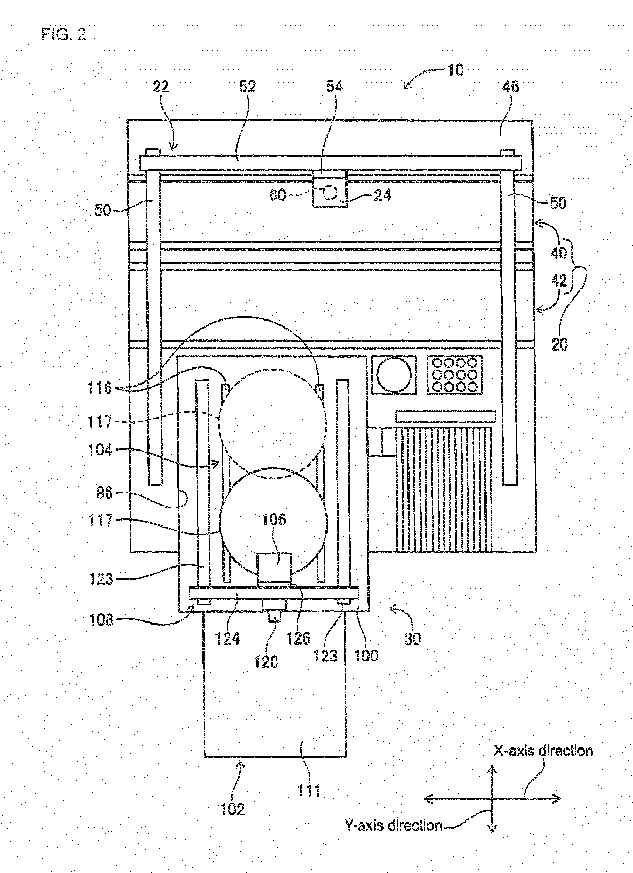

Figs. 1 and 2 show electronic component mounter 10 of an embodiment of the present invention. Fig. 1 is a perspective view of electronic component mounter 10, and fig. 2 is a plan view showing electronic component mounter 10 from which cover 12 and the like have been removed. Electronic component mounter 10 is a work machine that mounts electronic components on a circuit board. Electronic component mounter 10 is provided with conveyance device 20, mounting head moving device (hereinafter in some cases abbreviated to "moving device") 22, mounting head 24, and die supply device 30. Note that, in the following description, the width direction of electronic component mounter 10 is referred to as the X-axis direction and a horizontal direction orthogonal to the X-axis direction is referred to as the Y-axis direction.

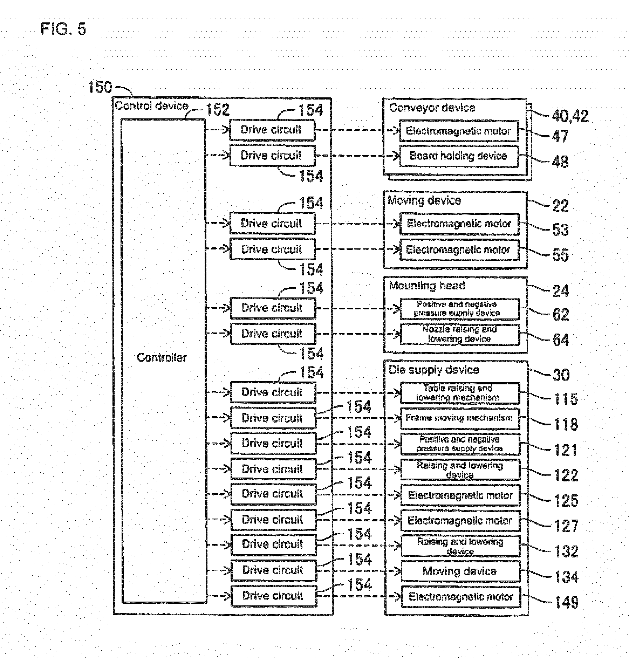

Conveyance device 20 is provided with conveyor devices 40 and 42. These two conveyor devices 40 and 42 are provided on base 46 parallel to each other and extending in the X-axis direction. Each of the two conveyor devices 40 and 42 conveys a circuit board in the X-axis direction by the driving of electromagnetic motor (refer to fig. 5) 47. Also, the circuit board is fixedly held at a specified position by board holding device (refer to fig. 5) 48.

Moving device 22 includes a pair of Y-axis direction guide rails 50 extending in the Y-axis direction and an X-axis direction guide rail 52 extending in the X-axis direction. X-axis direction guide rail 52 is provided on the pair of Y-axis direction guide rails 50. Further, X-axis direction guide rail 52 is moved to any position in the Y-axis direction by the driving of electromagnetic motor (refer to fig. 5) 53. Furthermore, X-axis direction guide rail 52 holds slider 54 that can move along an axis line thereof. Slider 54 is moved to any position in the X-axis direction by the driving of electromagnetic motor (refer to fig. 5) 55. Mounting head 24 is attached to slider 54. According to such a structure, mounting head 24 is moved to any position on base 46.

Mounting head 24 mounts electronic components on a circuit board. Mounting head 24 includes suction nozzle 60 that is provided on a lower end face of the mounting head. Suction nozzle 60 is connected to positive and negative pressure supply device (refer to fig. 5) 62 via a negative pressure air and positive pressure air supply passage. Suction nozzle 60 picks up and holds an electronic component using negative pressure, and releases the held electronic component using positive pressure. Also, mounting head 24 has nozzle raising and lowering device (refer to fig. 5) 64 that raises and lowers suction nozzle 60. Mounting head 24 changes the vertical position of a held electronic component by nozzle raising and lowering device 64. Note that, suction nozzle 60 is detachably mounted on mounting head 24.

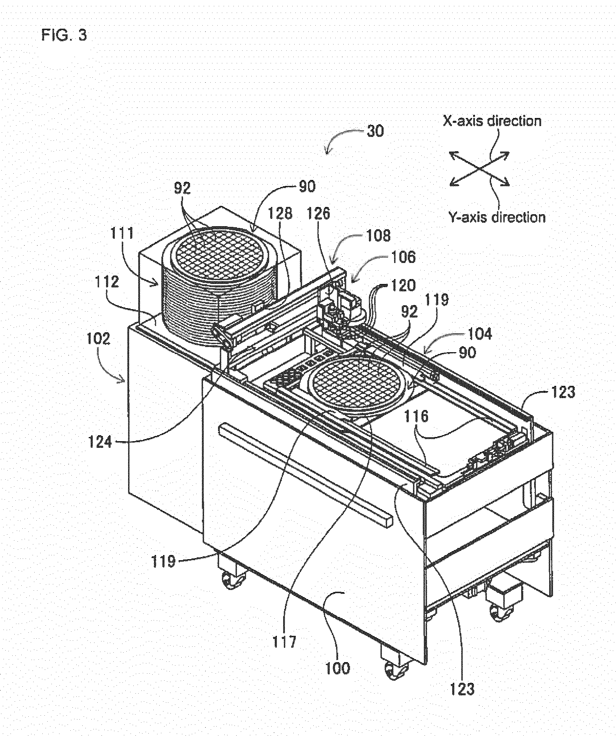

Die supply device 30 is provided at one end of base 46 in the Y-axis direction. In detail, storage section 86 having a recessed shape is formed at an edge of base 46, and a portion of die supply device 30 is stored in storage section 86. As shown in fig. 3, die supply device 30 supplies die 92 from die body 90. Die body 90 is formed by dicing a wafer to which a dicing sheet has been attached. Die body 90 is also referred to as a "wafer", and dies 92 are also referred to as "chips".

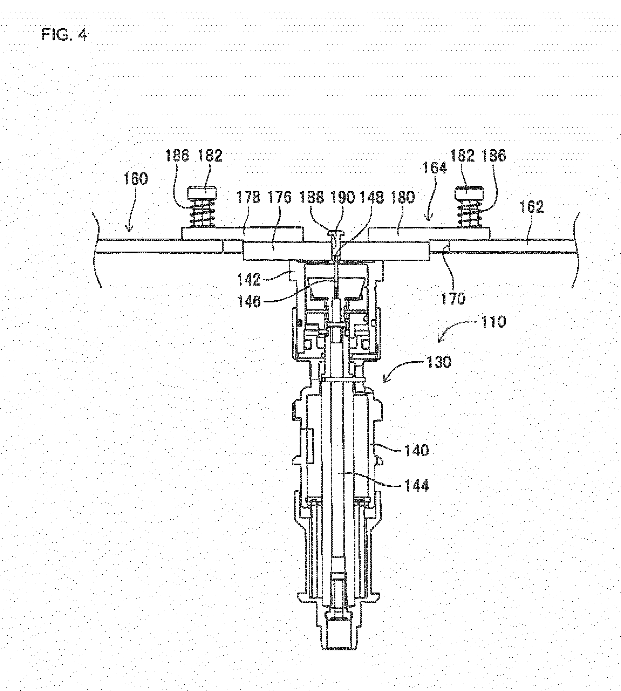

Die supply device 30 includes main frame 100, die body housing device 102, die body holding device 104, pickup head 106, pickup head moving device (hereinafter, referred to as a "moving device") 108, and die pushing unit (refer to fig. 4) 110.

The upper surface of main frame 100 is formed into a substantial rectangle shape, and die body holding device 104, pickup head 106, and moving device 108 are provided on the upper surface. Die supply device 30 is attached to base 46 by main frame 100 being stored in storage section 86.

Die body housing device 102 is connected to an end section in the Y-axis direction of main frame 100 and includes rack 111 and raising and lowering table 112. Rack 111 is provided on raising and lowering table 112, and multiple die bodies 90 are stored stacked in rack 111. The multiple die bodies 90 are moved in the vertical direction by raising and lowering table 112 being raised and lowered by table raising and lowering mechanism (refer to fig. 5) 115. Further, a die body 90 positioned at a predetermined height is drawn onto die body holding unit 104. Note that, die body 90 includes die bodies 90 of various sizes, such as 6-inch (15,24 cm), 8-inch (20,32 cm), and so on, and die bodies 90 of each size can be stored in rack 111.

As shown in figs. 2 and 3, die body holding device 104 includes a pair of guide rails 116 and holding frame 117. The pair of guide rails 116 are provided on main frame 100 extending in the Y-axis direction, and support holding frame 117 such that holding frame 117 is movable in the Y-axis direction. And, holding frame 117 is moved in the Y-axis direction along guide rails 116 by frame moving mechanism (refer to fig. 5) 118. Die body 90 pulled out from die body housing device 102 is loaded on top of holding frame 117. Further, fixing mechanism 119 is provided on holding frame 117. Fixing mechanism 119 fixes die body 90 along two opposite edges of die body 90 so as to position die body 90 on the top surface of holding frame 117.

Pickup head 106 picks up die 92 from die body 90; multiple suction nozzles 120 are mounted on the lower surface of pickup head 106. Each suction nozzle 120 is connected to positive and negative pressure supply device (refer to fig. 5) 121. Suction nozzle 120 picks up and holds die 92 using negative pressure, and releases held die 92 using positive pressure. Further, pickup head 106 is inverted in the vertical direction such that the opening of suction nozzle 120 faces upward. Accordingly, die 92 which has been picked up and held by suction nozzle 120 is supplied at an upper section of pickup head 106. Also, pickup head 106 includes raising and lowering device (refer to fig. 5) 122, with each suction nozzle 120 being raised and lowered by operation of raising and lowering device 122.

Moving device 108 includes a pair of Y-axis direction guide rails 123 extending in the Y-axis direction and an X-axis direction guide rail 124 extending in the X-axis direction. X-axis direction guide rail 124 is provided on the pair of Y-axis direction guide rails 123. Further, X-axis direction guide rail 124 is moved to any position in the Y-axis direction by the driving of electromagnetic motor (refer to fig. 5) 125. Also, the X-axis direction guide rail 124 holds slider 126 that can move along an axis line thereof. Slider 126 is moved to any position in the X-axis direction by the driving of electromagnetic motor (refer to fig. 5) 127. Pickup head 106 is attached to slider 126. According to such a structure, pickup head 106 is moved to any position on main frame 100.

Clamp 128 is mounted on the back of X-axis direction guide rail 124 of moving device 108. Clamp 128 grips die body 90 stored in rack 111 of the die body housing device 102. And, die body 90 gripped by clamp 128 is moved in the Y-axis direction by X-axis direction guide rail 124 being moved in the Y-axis direction. Accordingly, die body 90 stored in rack 111 is drawn onto holding frame 117.

Die pushing unit 110 is arranged below holding frame 117 of die body holding device 104, and includes pushing device (refer to fig. 4) 130, raising and lowering device (refer to fig. 5) 132, and moving device (refer to fig. 5) 134. As shown in fig. 4, raising device 130 includes main body section 140, contacting section 142, raising and lowering rod 144, and pushing pin 146. Main body section 140 is substantially a cylindrical tube, and is arranged below holding frame 117 in an upright state. Contacting section 142 is substantially a cylindrical tube with a lid, and covers an opening in the top end of main body section 140. Note that, through-hole 148 is formed on the center of the lid section of contacting section 142.

Further, raising and lowering robot 144 is held on an inside section of main body section 140 to be movable in a vertical direction, and is raised and lowered by the driving of electromagnetic motor (refer to fig. 5) 149. Note that, the top end of raising and lowering rod 144 is positioned inside contacting section 142. Pushing pin 146 is fixed coaxially to the top end of raising and lowering rod 144, such that pushing pin 146 is raised and lowered in accordance with the raising and lowering of raising and lowering rod 144. The external diameter of pushing pin 146 is smaller than the internal diameter of through-hole 148 of contacting section 142, and the leading end of pushing pin 146 is inserted into through-hole 148. Note that, when raising and lowering rod 144 is lowered to the lowest position, the top end of pushing pin 146 and the top end of contacting section 142 are at the same position in the vertical direction. That is, the top end surface of pushing pin 146 and the top end surface of contacting section 142 are at the same level. Further, the top end of pushing pin 146 protrudes from the upper surface of contacting section 142 in accordance with the raising of raising and lowering rod 144.

Further, raising and lowering device 132 raises and lowers pushing device 130 in the vertical direction. Moving device 134 moves pushing device 130 to any position in the X-axis direction and the Y-axis direction below die body holding device 104. According to such a structure, die pushing unit 110, as described in detail later, uses pushing pin 146 to push a given die of die body 90 held by die body holding device 104.

Further, as shown in fig. 5, electronic component mounter 10 is provided with control device 150. Control device 150 is provided with controller 152 and multiple drive circuits 154. The multiple drive circuits 154 are connected to the above electromagnetic motors 47, 53, 55, 125, 127, and 149, board holding device 48, positive and negative pressure supply devices 62 and 121, nozzle raising and lowering device 64, table raising and lowering device 115, frame moving mechanism 118, raising and lowering devices 122 and 132, and moving device 134. Controller 152 is formed mainly from a computer, provided with a CPU, ROM, RAM, and so on, and connected to the multiple drive circuits 156. Accordingly, operation of conveyance device 20, moving device 22, and the like is controlled by controller 152.

### Mounting work by the electronic component mounter

Mounting work of mounting dies 92 on a circuit board is performed by electronic component mounter 10 with the above structure. Specifically, based on commands of controller 152 of control device 150, the circuit board is conveyed to a work position, and fixedly held at that position. Further, die supply device 30 supplies the die 92 using pickup head 106.

Specifically, according to instructions from controller 152, raising and lowering table 112 is raised and lowered, and a given die body 90 among the multiple die bodies 90 stored in rack 111 is moved to a position opposite clamp 128. Then, die body 90 is clamped by clamp 128 and X-axis direction guide rail 124 is moved in the Y-axis direction. Accordingly, die body 90 clamped by clamp 128 is pulled onto holding frame 117. Note that, the die body 90 pulled from rack 111 is positioned on holding frame 117 at the position shown by the solid line in fig. 2. Further, die body 90 pulled onto holding frame 117 is fixed by fixing mechanism 119. Next, pickup head 106 is moved above the die 92 that is to be picked up, and the die 92 is picked up by suction nozzle 120.

Here, pushing device 130 is moved below the die 92 to be held by suction nozzle 120 of pickup head 106, and raising and lowering rod 144 is raised at that position. Thus, die 92 is raised and peeled from the dicing sheet. Thus, pickup of die 92 by suction nozzle 120 is supported. In detail, pushing device 130 is moved below the die 92 that is to be picked up by operation of moving device 134. Then, pushing device 130 is raised by operation of raising and lowering device 132 until contacting section 142 of pushing device 130 contacts the lower surface of die body 90 held by holding frame 117. Continuing, raising and lowering rod 144 is raised with die 92 in a state being held by suction nozzle 120. This, the die 92 being held by section nozzle 120 is raised by pushing pin 146 such that die 92 is peeled from the dicing sheet. Then, by raising suction nozzle 120, the die 92 is picked up by suction nozzle 120. Accordingly, the die 92 adhered to the dicing sheet is appropriately picked up by suction nozzle 120. Note that, when raising and lowering rod 144 is raised, that is, when pushing pin 146 is raising the die 92, suction nozzle 120 is also raised by an amount in accordance with the raising amount of raising and lowering rod 144. Thus, the load applied to die 92 that is sandwiched between pushing pin 146 and section nozzle 120 is curtailed. Note that, the raising amount of raising and lowering rod 144, that is, the raising of the die 92 by pushing pin 146, is set according to factors such as the adhesive strength of the dicing sheet, and is approximately 0.1 to 0.5 mm.

Next, the die 92 picked up by suction nozzle 120 is flipped vertically by pickup head 106. Accordingly, die 92 which has been picked up and held by suction nozzle 120 is supplied at an upper section of pickup head 106. When the die 92 is supplied to the upper section of pickup head 106, mounting head 24 is moved to a position above pickup head 106 and suction nozzle 60 picks up the die 92. That is, the die 92 is transferred from suction nozzle 120 of pickup head 106 to suction nozzle 60 of mounting head 24. Then, mounting head 24 is moved above the circuit board and the die 92 is mounted on the circuit board.

Further, with die supply device 30, the die 92 can be directly supplied from die supply device 30 without the use of pickup head 106. In detail, after die body 90 is pulled out from rack 111 onto holding frame 117, holding frame 117 is moved in the Y-axis direction. Thus, die body 90 is positioned above holding frame 117 shown by the dashed line in fig. 2. Then, mounting head 24 is moved above die body 90, and the die 92 is picked up by suction nozzle 60 using suction. Note that, when the die 92 is picked up by suction nozzle 60, similar to when the die 92 is picked up by suction nozzle 120, the die 92 is pushed up by die pushing unit 110. Then, the die 92 picked up by suction nozzle 60 is mounted on the circuit board.

### Measuring the push amount of the pushing device

With die supply device 30, when a given die 92 from die body 90 held on holding frame 117 is picked up by suction nozzle 60 or suction nozzle 120, the die 92 is pushed up by operation of pushing device 130. Thus, the die 92 is peeled from the dicing sheet and picked up by suction nozzle 60 or 120.

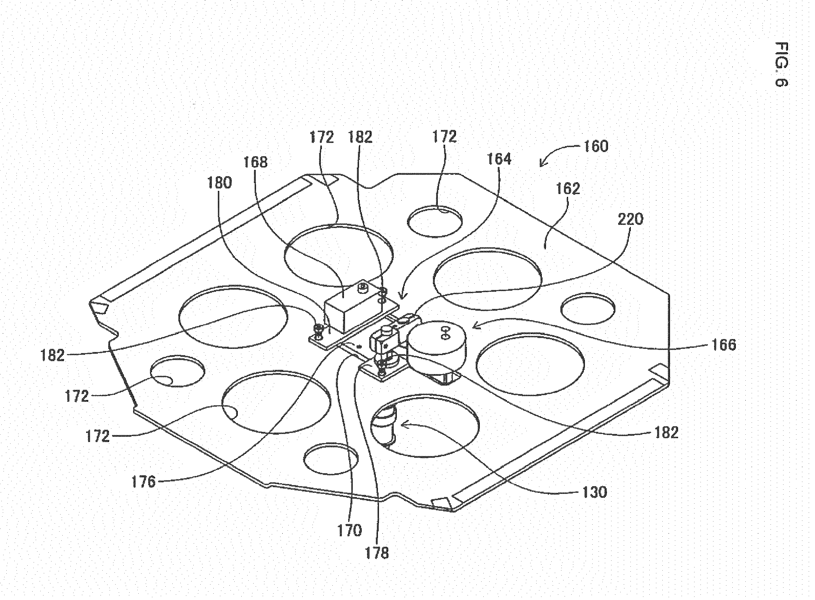

However, as described above, the push amount of the die 92 by pushing device 130 is set in advance based on factors such as the adhesive strength of the dicing sheet, and in a case in which the actual push amount of the die 92 does not reach the amount set in advance, that is, the die 92 pushed up by pushing device 130 is not raised to the appropriate height corresponding to the amount set in advance, the die 92 may not be peeled from the dicing sheet, and may not be picked up appropriately by suction nozzle 60 or 120. Further, when pushing up die 92, it is assumed that the die 92 is raised by the amount set in advance, thus suction nozzle 60 or 120 is raised by a distance corresponding to the amount set in advance. However, if the actual push amount of the die 92 is larger than the amount set in advance, and the die 92 pushed up by pushing device 130 is raised to a height higher than a height corresponding to the amount set in advance, an excessive load may be applied to the die 92 sandwiched between pushing pin 146 and suction nozzle 60 or 120, and the die 92 may be damaged. Thus, it is necessary to appropriately detect the push amount by pushing device 130. Considering this, with die supply device 30, the push amount by pushing device 130 is measured using measurement plate 160 shown in fig. 6. The configuration of measurement plate 160 is described in detail below.

### (a) Measure plate configuration

Measurement plate 160 includes main body plate 162, supplementary plate unit 164, dial indicator (lever type dial gauge) 166, and adjustment weight 168. Main plate 162 is formed of a plate with a thickness substantially the same thickness as die body 90, the external dimensions of main body plate 162 are substantially the same as the external dimensions of die body 90. In particular, the distance between a pair of sides opposite each other among the four sides of main body plate 162 is the same as the distance between a pair of sides opposite each other among the four sides of die body 90. Accordingly, because main body plate 162 has substantially the same dimensions as die body 90, similar to die body 90, measurement plate 160 can be housed inside die body housing device 102, loaded on holding frame 117 of die body holding device 104, and fixed by fixing mechanism 119.

Note that, as described above, die body 90 includes die bodies 90 of various sizes, such as 6-inch, 8-inch, and so on, and there are the same quantity of main body plates 162 as there are sizes and types of die bodies 90. That is, if there are three sizes of die bodies 90, 6-inch, 8-inch, and 12-inch, there are three types of measurement plate 160 including main body plates 162 with the same dimensions as the three sizes of die bodies 90.

Also, roughly square through-hole 170 is formed in a central portion of main body plate 162. Through-hole 170 is for arranging supplementary plate unit 164. Further, multiple round through-holes 172 are formed in main body plate 162, the multiple through-holes 172 being provided to make measurement plate 160 lighter.

Supplementary plate unit 164 is configured from measuring element holding plate 176 and a pair of fixing plates, 178 and 180. Measuring element holding plate 176 is a substantially square plate, and the outer dimensions of measuring element holding plate 176 are slightly smaller than the internal dimensions of through-hole 170 of main body plate 162. On the other hand, the pair of fixing plates, 178 and 180, are each substantially a rectangular plate with a length dimension on the longer side that is longer than the length dimension of the sides of the measuring element holding plate 176. Further, fixing plates 178 and 180 are fixed to an upper surface of measuring element holding plate 176 spaced apart such that the lengthwise direction of each of the fixing plates 178 and 180 is aligned with the direction in which a pair of opposite edges of measuring element holding plate 176 extend.

Also, measuring element holding plate 176 is arranged inside through-hole 170 of main body plate 162, and each of the fixing plates 178 and 180 is attached to an upper surface of main body plate 162 using screws 182 at both edges in the lengthwise direction. However, screw 182 only has a screw thread at the tip section, and each of the fixing plates 178 and 180 is biased to main body plate 162 by the elastic force of a coil spring provided on screw 182.

In detail, a through-hole (not shown) larger than the external diameter of screw 182 is formed in both ends of each of the fixing plates 178, and screw 182 is inserted into the through-hole. A screw thread is formed in the tip section of screw 182 such that the screw 182 can be fastened to main body plate 162. However, as shown in fig. 4, the shaft section of screw 182 is longer than the thickness dimension of fixing plates 178 and 180. Therefore, there is a gap between the head of screw 182 and the upper surface of fixing plates 178 and 180, and coil spring 186 is provided in a compressed state in between the upper surface of fixing plate 178 or 180 and the head of screw 182. Accordingly, fixing plates 178 and 180 are biased by the elastic amount of coil spring 186 towards main body plate 162 together with measuring element holding plate 176. According to such a configuration, when measuring element holding plate 176 of supplementary plate unit 164 is pressed up from the lower surface side of main body plate 162, supplementary plate unit 164 moves up against the elastic force of coil springs 186.

Also, through-hole 188 is formed in a central portion of measuring element holding plate 176 and raising and lowering element 190, which is a substantially cylindrical tube, is inserted into through-hole 188. The external diameter of raising and lowering element 190 is smaller than the internal diameter of through-hole 188, and raising and lowering element 190 is able to be raised and lowered inside through-hole 188. Note that, a flange section that is larger than the internal diameter of through-hole 188 is formed on the top end of raising and lowering element 190, with the flange section preventing raising and lowering element 190 falling through through-hole 188. Further, the length downwards from the flange section of raising and lowering element 190 is the same as the length dimension of through-hole 188 in the vertical direction. Therefore, in a state in which raising and lowering element 190 is lowered inside through-hole 188 as far as possible, the lower surface of raising and lowering element 190 and the upper surface of measuring element holding plate 176 are at the same position vertically, and are flush against each other.

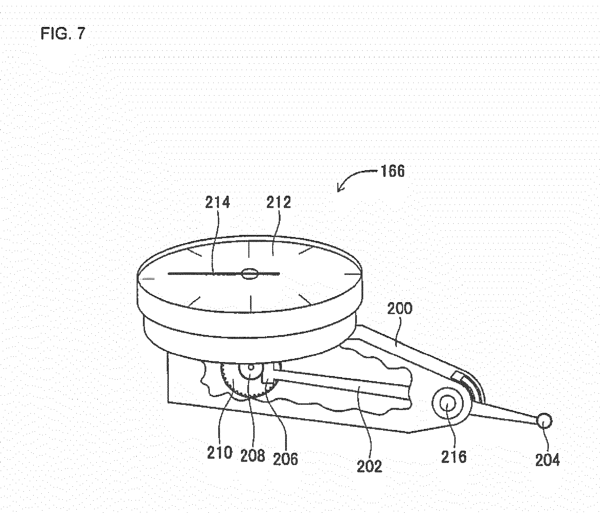

Also, as shown in fig. 7, dial indicator 166 includes housing 200, oscillating rod 202, measuring element 204, rack 206, pinion 208, gear 210, gradation plate 212, and needle 214, and a transmission mechanism (not shown). Housing 200 is an exterior member with a hollow inside; a base end of oscillating rod 202 is inserted inside housing 200, and a tip extends out from housing 200; axis 216 is held on an end section of housing 200 so as to allow oscillation. Also, measuring element 204 is a sphere fixed to the end of oscillating rod 202 protruding outside from housing 200.

Rack 206 is formed on the base end of oscillating rod 202 positioned inside housing 200, and pinion 208 is engaged with rack 206. Pinion 208 is coaxially fixed to gear 210, such that pinion 208 and gear 210 are rotatably held inside housing 200. Gradation plate 212 is arranged on an upper surface of housing 200. A center shaft (not shown) is provided at the center of gradation plate 212 to be rotatable around its own axis, and an end of needle 214 is fixed at a rightangle to the center shaft. The center shaft of needle 214 is connected to gear 210 via a transmission mechanism. The transmission mechanism converts the rotation of gear 210 into rotation of the center shaft of needle 214. Thus, when oscillating rod 202 oscillates, pinion 208 and gear 210 rotate coaxially, and that rotation is transmitted to the center shaft of needle 214 by the transmission mechanism. Then, needle 214 rotates around the center shaft such that the tip of needle 214 points to a specified gradation marking provided on gradation plate 212. Thus, a value according to the specified gradation marking is displayed, in other words, is output. According to such a configuration, dial indicator measures the oscillation amount of oscillating rod 202, that is, the movement amount in the vertical direction of measuring element 204.

Note that, dial indicator 166 includes a peak hold function. A peak hold function is a function for maintaining needle 214 in a state with the maximum value displayed when needle 214 is rotated. In other words, when oscillating rod 202 is oscillated such that measuring element 204 moves upwards, needle 214 rotates to indicate the gradation marking in accordance with raising amount of measuring element 204. Then, even if oscillating rod 202 is oscillated in a direction such that measurement element 207 moves downwards, needle 214 does not move and instead continues to indicate the gradation marking in accordance with the upper amount of measuring element 204. Thus, dial indicator 166 measures the maximum value of the upper limit amount of measuring element 204.

Also, as shown in fig. 6, dial indicator 166 is fixed to an upper surface of fixing plate 178 of supplementary plate unit 164 via fixing tool 220. Oscillating rod 202 of dial indicator 166 extends above measuring element holding plate 176 of supplementary plate unit 164, and measuring element 204 on the tip of oscillating rod 202 contacts the upper surface of raising and lowering element 190 of measuring element holding plate 176. Note that, at the position at which the measurement value of dial indicator 166 is zero, measuring element 204 is contacting the upper surface of raising and lowering element 190 lowered to the lowest position inside through-hole 188 of measuring element holding plate 176. That is, when raising and lowering element 190 is lowered to the lowest position, measuring element 204 contacts the upper surface of raising and lowering element 190, and the measurement value by dial gauge 166 at this point is zero. According to such a configuration, with measurement plate 160, oscillating rod 202 of dial indicator 166 oscillates in accordance with the raising and lowering of raising and lowering element 190 such that the movement amount of measuring element 204 in the vertical direction is measured by dial indicator 166.

Also, adjustment weight 168 is fixed to an upper surface of fixing plate 180. The weight of adjustment weight 168 is the same as the weight of dial indicator 166, and the weight balance between the fixing plate 178 side and the fixed plate 180 side of supplementary plate unit 164 is made even using adjustment weight 168.

### (b) Measuring the push amount using the measuring plate

Described below is the method for measuring the push amount of pushing device 130 using measurement plate 160 with the construction given above. First, an operator houses a measurement plate 160 the same size as die body 90 of the dies 92 to be supplied in rack 111 of die body housing device 102. Next, based on an instruction from controller 152, raising and lowering table 112 is lowered, and the measurement plate 160 housed in rack 111 is moved to a position facing clamp 128. Then, measurement plate 160 is gripped by clamp 128, and X-axis direction guide rail 124 is moved in the Y-axis direction. Accordingly, measurement plate 160 is gripped by clamp 128 and pulled above holding frame 117. Then, measurement plate pulled out above holding frame 117 is fixed by fixing mechanism 119.

Next, pushing device 130 is moved by operation of moving device 134 below measurement plate 160 held by holding frame 117. Here, pushing device 130 is moved below measurement plate 160 such that through-hole 148 of pushing device 130 and through-hole 188 of measurement plate 160 are aligned in the vertical direction. Also, pushing device 130 is raised by operation of raising and lowering device 132 until contacting section 142 of pushing device 130 contacts the lower surface of measuring element holding plate 176 of measurement plate 160. Accordingly, through-hole 148 of pushing device 130 and through-hole 188 of measurement plate 160 are connected. Further, as described above, pushing pin 146 of pushing device 130 is inserted inside through-hole 148, and the tip end surface of pushing pin 146 and the upper surface of contacting section 142 are flush against each other. On the other hand, the lower end surface of raising and lowering element 190 inserted into through-hole 188 and the lower surface of measuring element holding plate 176 are also flush against each other. Therefore, in a state with contacting section 142 contacting the lower surface of measuring element holding plate 176, the tip end surface of pushing pin 146 contacts the lower end surface of raising and lowering element 190.

Further, electric power is supplied to electromagnetic motor 149 in accordance with a push amount of pushing pin 146 set in advance (hereinafter also referred to as "set push amount"). By this, pushing pin 146 is raised and raising and lowering element 190 is pushed up. Here, in accordance with the raising of raising and lowering element 190, measuring element 204 is raised, and oscillating rod 202 oscillates. Thus, needle 214 of dial indicator 166 rotates and points to a gradation marking that indicates the upper limit amount of measuring element 204, that is, the push amount of pushing pin 146. Note that, when the supply of electric power to electromagnetic motor 149 is stopped, pushing pin 146 is lowered, so raising and lowering element 190 and measuring element 204 are also lowered. Here, oscillating rod 202 returns to its position before oscillation, but due to the peak holding function, dial indicator 166 maintains a state in which needle 214 points to the gradation marking indicating the maximum push amount of pushing pin 146.

Further, when measurement of the push amount of pushing pin 146 is complete, measurement plate 160 is gripped by clamp 128 and X-axis direction guide rail 124 is moved towards die body housing device 102. Thus, measurement plate 160 is returned to rack 111. Then, an operator removes measurement plate 160 from rack 111 and reads the gradation marking of dial indicator 166 of measurement plate 160. Here, the read value is the actual push amount of pushing pin 146.

Further, calibration is performed based on the actual push amount. Specifically, for example, the difference between the actual push amount and the set push amount may be calculated and the amount of electricity supplied to electromagnetic motor 149 may be adjusted based on the difference. By this, the actual push amount and the set push amount can be made to match, such that pickup of a die 92 by suction nozzle 60 or 120 can be supported appropriately.

In particular, by using measurement plate 160, it is possible to measure the push amount of pushing pin 146 at a position close to where die 92 is actually peeled from die body 90, making it possible to measure a push amount equivalent to a push amount on die 92 by pushing pin 146. Accordingly, it is possible to perform appropriate calibration.

Also, with measurement plate 160, supplementary plate unit 164 is biased towards main body plate 162 by an elastic force, so when measuring the push amount of pushing pin 146, contacting section 142 of pushing device 130 contacts measuring element holding plate 176 of supplementary plate unit 164. Therefore, for example, even in a case in which measurement plate 160 held by holding frame 117 and pushing pin 146 of pushing device 130 are not in a line, due to contact by contacting section 142, supplementary plate unit 164 is raised against the elastic force, and measuring element holding plate 176 of supplementary plate unit 164 and pushing pin 146 are made to be in a line. This ensures the appropriate measurement of the push amount of pushing pin 146.

Further, measurement plate 160 has the same dimensions as die body 90, such that housing of measurement plate 160 in rack 111, holding of measurement plate 160 by holding frame 117, and fixing of measurement plate 160 by fixing mechanism 119 can be performed in a similar manner to die body 90. Thus, it is possible to appropriately measure the push amount of pushing pin 146 just by preparing measurement plate 160, without needing to improve die supply device 30. Also, the push amount of pushing pin 146 is measured simply by an operator setting measurement plate 160 in rack 111; other work is performed by operation of electronic component mounter 10. Thus, the workload on the operator is reduced.

Note that, in the above embodiments, die supply device 30 is an example of a die supply device. Die body 90 is an example of a die body. Die 92 is an example of a die. Moving device 108 and clamp 128 are an example of a pulling out device. Rack 111 is an example of a housing section. Holding frame 117 is an example of a holding stage. Fixing mechanism 119 is an example of a fixing mechanism. Pushing device 130 is an example of a pushing device. Contacting section 142 is an example of a contacting section. Pushing pin 146 is an example of a pushing tool. Measurement plate 160 is an example of a holding plate. Main body plate 162 is an example of a main body plate. Supplementary plate unit 164 is an example of a biasing plate. Dial indicator 166 is an example of a detecting tool.

Modifications are possible. Specifically, for example, in an embodiment above, the push amount of pushing pin 146 is measured by dial indicator 166, but an apparatus in which a measurement rod moves in an axial line direction, such as a standard dial gauge, and that measures the push amount of pushing pin 146 based on the movement amount of the measurement rod in the axial direction may be used. Also, instead of a mechanical sensor such as dial indicator 166, an optical sensor that uses electromagnetic waves such as a laser may be used as an apparatus to measure the push amount of pushing pin 146.

Also, in an embodiment above, the measured push amount of pushing pin 146 is checked visually by an operator, but the measured push amount may be sent to control device 150 or the like. In detail, an item with a communication device may be used as a detecting tool that detects the push amount of pushing pin 146, and the detected push amount, that is, the actual push amount may be sent to control device 150 or the like. Then, calibration may be performed by control device 150 or the like based on the actual push amount. Accordingly, the load on the operator is reduced even further.

Also, in an embodiment above, the push amount of pushing pin 146 is output by needle 214 pointing to a gradation marking, but the push amount of pushing pin 146 may be output by the value being displayed on a screen or by using sound or the like. Alternatively, the push amount of pushing pin 146 may be output by being sent to another device.

### Reference Signs List

- 30:: die supply device;
- 90:: die body;
- 92:: die;
- 108:: moving device (pulling out device);
- 111:: rack (housing section);
- 117:: holding frame (holding stage);
- 119:: fixing mechanism;
- 130:: pushing device;
- 142:: contacting section;
- 146:: pushing pin (pushing tool);
- 160:: measurement plate (holding plate);
- 162:: main body plate;
- 164:: supplementary plate unit (biasing plate);
- 166:: dial indicator (detecting tool)

## Claims

1. A system comprising a die supply device (30) and a holding plate (160), the die supply device (30) including a holding stage (117) configured to hold one of the holding plate (160) and a die body (90) configured from multiple dies (92) and a pushing tool (146) configured to push from below a given die (92) from the die body (90) held by the holding stage (117), the die supply device (30) being configured to supply dies (92) in a state raised by the pushing tool **(146),characterized in that** the holding plate (160) comprises a detecting tool (166) for detecting a push amount of the pushing tool (146).

2. The system according to claim 1, wherein the die supply device (30) is provided with a fixing mechanism (119) configured to decide the position of the die body (90) on the holding stage (117) by fixing the die body (90) held by the holding stage (117) at at least two sides, and the holding plate (160) is positioned on the holding stage (117) by being fixed at least two sides by the fixing mechanism (119).

3. The system according to claim 1 or 2, wherein the detecting tool (166) detects a maximum value push amount of the pushing tool (146) and outputs the maximum value.

4. The system according to any one of the claims 1 to 3, wherein the holding plate (160) includes
a main body plate (162) in which a through-hole is formed, and
a biasing plate (164) that covers the through-hole and that is arranged in a state biased towards the main body plate (162) by an elastic force, and
the detecting tool (166) is arranged on the biasing plate (164).

5. A detecting method for detecting a push amount of a pushing tool (146), the detecting method comprising:
holding a holding plate (160) on a holding stage (117);
contacting a contacting section (142) against a biasing plate (164) of the holding plate (160) held on the holding stage (117); and
detecting the push amount of the pushing tool (146) using a detecting tool (166) in a state in which the contacting section (142) is contacting the biasing plate (164),
the method being used in a die supply device (30) configured to supply a die (92) in a state raised by the pushing tool (146), the die supply device (30) being provided with
the holding stage (117) configured to hold one of the holding plate (160) and a die body (90) configured from multiple dies (92), and
a pushing device (130) including
(a) the contacting section (142) configured to contact an underside of the die body (90) held by the holding stage (117), and
(b) the pushing tool (146) configured to protrude upwards from the contacting section (142) and to push from below a given die (92) of the die body (90) contacted by the contacting section (142),
wherein
the holding plate (160) is configured to be held by the holding stage (117), the holding plate (160) including
a main body plate (162) in which a through-hole is formed,
the biasing plate (164) configured to cover the through-hole and arranged in a state biased towards the main body plate (162) by an elastic force, and
the detecting tool (166) arranged on the biasing plate (164) and configured to detect the push amount of the pushing tool (146).

6. The system according to one of claims 1 to 4, wherein the die supply device (30) further comprises:
a housing section (111) configured to house both the holding plate (160) including the detecting tool (166) for detecting a push amount of the pushing tool (146), and a die body (90) configured from multiple dies (92),
a pulling out device (108) configured to pull out from the housing section (111) one of the die body (90) and the holding plate (160);
the holding stage (117) configured to hold one of the die body (90) and the holding plate (160) pulled out from the housing section (111) by the pulling out device (108);
wherein
in a case in which the die body (90) is being held by the holding stage (117), the die (92) is supplied in a state being pushed by the pushing tool (146), and
in a case in which the holding plate (160) is being held by the holding stage (117), the push amount of the pushing tool (146) is detected by the detecting tool (166).

## Patentansprüche

1. System, das eine Chip-Zuführvorrichtung (30) und eine Halteplatte (160) umfasst,
wobei die Chip-Zuführvorrichtung (30) enthält:
einen Haltetisch (117), der so ausgeführt ist, dass er die Halteplatte (160) oder einen Chip-Körper (90) hält, der aus mehreren Chips (92) besteht, und
eine Drückvorrichtung (146), die so ausgeführt ist, dass sie einen bestimmten Chip (92) von unten aus dem von dem Haltetisch (117) gehaltenen Chip-Körper (90) drückt,
wobei die Chip-Zuführvorrichtung (30) so ausgeführt ist, dass sie Chips (92) in einem durch die Drückvorrichtung (146) angehobenen Zustand zuführt, **dadurch gekennzeichnet, dass**
die Halteplatte (160) eine Erfassungsvorrichtung (166) zum Erfassen einer Drückkraft der Drückvorrichtung (146) umfasst.

2. System nach Anspruch 1, wobei
die Chip-Zuführvorrichtung (30) mit einem Fixiermechanismus (119) versehen ist, der so ausgeführt ist, dass er die Position des Chip-Körpers (90) auf dem Haltetisch (117) bestimmt, indem er den von dem Haltetisch (117) gehaltenen Chip-Körper (90) an wenigstens zwei Seiten fixiert, und
die Halteplatte (160) auf dem Haltetisch (117) positioniert wird, indem sie durch den Fixiermechanismus (119) an wenigstens zwei Seiten fixiert wird.

3. System nach Anspruch 1 oder 2, wobei
die Erfassungsvorrichtung (166) einen Maximalwert der Drückkraft der Drückvorrichtung (146) erfasst und den Maximalwert ausgibt.

4. System nach einem der Ansprüche 1 bis 3, wobei
die Halteplatte (160) enthält:
eine Hauptkörper-Platte (162), in der ein Durchgangsloch ausgebildet ist, sowie
eine Vorspann-Platte (164), die das Durchgangsloch abdeckt und die in einem Zustand angeordnet ist, in dem sie durch eine elastische Kraft auf die Hauptkörper-Platte (162) zu vorgespannt wird, und
die Erfassungsvorrichtung (166) an der Vorspann-Platte (164) angeordnet ist.

5. Erfassungsverfahren zum Erfassen einer Drückkraft einer Drückvorrichtung (146), wobei das Erfassungsverfahren umfasst:
Halten einer Halteplatte (160) an einem Haltetisch (117);
Herstellen von Kontakt eines Kontaktherstellungs-Abschnitts mit einer Vorspann-Platte (164) der an dem Haltetisch (117) gehaltenen Halteplatte (160); sowie
Erfassen der Drückkraft der Drückvorrichtung (146) unter Verwendung einer Erfassungsvorrichtung (166) in einem Zustand, in dem der Kontaktherstellungs-Abschnitt (142) mit der Vorspann-Platte (164) in Kontakt ist,
wobei das Verfahren in einer Chip-Zuführvorrichtung (30) eingesetzt wird, die so ausgeführt ist, dass sie einen Chip (92) in einem durch die Drückvorrichtung (146) angehobenen Zustand zuführt, wobei die Chip-Zuführvorrichtung (30) versehen ist mit:
einen Haltetisch (117), der so ausgeführt ist, dass er die Halteplatte (160) oder einen Chip-Körper (90) hält, der aus mehreren Chips (92) besteht, und
eine Drückvorrichtung (130), die enthält:
(a) den Kontaktherstellungs-Abschnitt (142), der so ausgeführt ist, dass er mit einer Unterseite des von dem Haltetisch (117) gehaltenen Chip-Körpers (90) in Kontakt kommt, und
(b) die Drückvorrichtung (146), die so ausgeführt ist, dass sie von dem Kontaktherstellungs-Abschnitt (142) nach oben vorsteht und von unten auf einen bestimmten Chip (92) des mit dem Kontaktherstellungs-Abschnitt (142) in Kontakt befindlichen Chip-Körpers (90) drückt,
wobei
die Halteplatte (160) so ausgeführt ist, dass sie von dem Haltetisch (117) gehalten wird, wobei die Halteplatte (160) enthält:
eine Hauptkörper-Platte (162), in der ein Durchgangsloch ausgebildet ist,
die Vorspann-Platte (164), die so ausgeführt ist, dass sie das Durchgangsloch abdeckt, und in einem Zustand angeordnet ist, in dem sie durch eine elastische Kraft auf die Hauptkörper-Platte (162) zu vorgespannt wird, sowie
die Erfassungsvorrichtung (166), die an der Vorspann-Platte (164) angeordnet und so ausgeführt ist, dass sie die Drückkraft der Drückvorrichtung (146) erfasst.

6. System nach einem der Ansprüche 1 bis 4, wobei die Chip-Zuführvorrichtung (30) des Weiteren umfasst:
einen Aufnahmeabschnitt (111), der so ausgeführt ist, dass er sowohl die Halteplatte (160), die die Erfassungsvorrichtung (166) zum Erfassen einer Drückkraft der Drückvorrichtung (146) enthält, als auch einen Chip-Körper (90) aufnimmt, der aus mehreren Chips (92) besteht,
eine Herauszieh-Vorrichtung (108), die so ausgeführt ist, dass sie den Chip-Körper (90) oder die Halteplatte (160) aus dem Gehäuseabschnitt (111) herauszieht;
den Haltetisch (117), der so ausgeführt ist, dass er entweder den Chip-Körper (90) oder die Halteplatte (160) hält, der/die durch die Herauszieh-Einrichtung (108) aus dem Gehäuseabschnitt (111) herausgezogen wird;
wobei
wenn der Chip-Körper (90) von dem Haltetisch (117) gehalten wird, der Chip (92) in einem Zustand zugeführt wird, in dem er von der Drückvorrichtung (146) gedrückt wird, und
wenn die Halteplatte (160) von dem Haltetisch (117) gehalten wird, die Drückkraft der Drückvorrichtung (146) durch die Erfassungsvorrichtung (166) erfasst wird.

## Revendications

1. Système comprenant un dispositif d'alimentation de puces électroniques (30) et une plaque de support (160),
le dispositif d'alimentation de puces électroniques (30) comprenant
un plateau de support (117) configuré pour supporter un élément parmi la plaque de support (160) et un corps de puce électronique (90) configuré pour de multiples puces électroniques (92) et
un outil de poussée (146) configuré pour pousser une puce électronique donnée (92) par le bas depuis le corps de puce électronique (90) supporté par le plateau de support (117),
le dispositif d'alimentation de puces électroniques (30) étant configuré pour alimenter des puces électroniques (92) dans un état relevé par l'outil de poussée (146),
**caractérisé en ce que** la plaque de support (160) comprend un outil de détection (166) pour détecter une quantité de poussée de l'outil de poussée (146).

2. Système selon la revendication 1, dans lequel le dispositif d'alimentation de puces électroniques (30) est pourvu d'un mécanisme de fixation (119) configuré pour décider de la position du corps de puce électronique (90) sur le plateau de support (117) en fixant le corps de puce électronique (90) supporté par le plateau de support (117) sur au moins deux côtés, et la plaque de support (160) est positionnée sur le plateau de support (117) en étant fixée sur au moins deux côtés par le mécanisme de fixation (119).

3. Système selon la revendication 1 ou 2, dans lequel l'outil de détection (166) détecte une valeur maximale de quantité de poussée de l'outil de poussée (146) et sort la valeur maximale.

4. Système selon l'une quelconque des revendications 1 à 3, dans lequel
la plaque de support (160) comprend
une plaque du corps principal (162) dans laquelle est formé un trou traversant, et
une plaque de contrainte (164) qui recouvre le trou traversant et est agencée dans un état contraint vers la plaque de corps principal (162) par une force élastique, et
l'outil de détection (166) est agencé sur la plaque de contrainte (164).

5. Procédé de détection pour détecter une quantité de poussée d'un outil de poussée (146), le procédé de détection comprenant :
le support d'une plaque de support (160) sur un plateau de support (117) ;
la mise en contact d'une section de contact (142) contre une plaque de contrainte (164) de la plaque de support (160) supportée sur le plateau de support (117) ; et
la détection de la quantité de poussée de l'outil de poussée (146) en utilisant un outil de détection (166) dans un état où la section de contact (142) est en contact avec la plaque de contrainte (164),
le procédé étant utilisé dans un dispositif d'alimentation de puces électroniques (30) configuré pour alimenter une puce électronique (92) dans un état relevé par l'outil de poussée (146), le dispositif d'alimentation de puces électroniques (30) étant pourvu
du plateau de support (117) configuré pour supporter un élément parmi la plaque de support (160) et un corps de puce électronique (90) configuré à partir de multiples puces électroniques (92), et
d'un dispositif de poussée (130) comprenant
(a) la section de contact (142) configurée pour entrer en contact avec un côté inférieur du corps de puce électronique (90) supporté par le plateau de support (117), et
(b) l'outil de poussée (146) configuré pour ressortir vers le haut depuis la section de contact (142) et pour pousser par le bas une puce électronique donnée (92) du corps de puce électronique (90) avec laquelle la section de contact (142) est en contact,
dans lequel
la plaque de support (160) est configurée pour être supportée par le plateau de support (117), la plaque de support (160) comprenant
une plaque du corps principal (162) dans laquelle est formé un trou traversant,
la plaque de contrainte (164) configurée pour recouvrir le trou traversant et agencée dans un état contraint vers la plaque du corps principal (162) par une force élastique, et
l'outil de détection (166) agencé sur la plaque de contrainte (164) et configuré pour détecter la quantité de poussée de l'outil de poussée (146).

6. Système selon l'une des revendications 1 à 4, dans lequel le dispositif d'alimentation de puces électroniques (30) comprend en outre :
une section de boîtier (111) configurée pour recevoir aussi bien la plaque de support (160) comprenant l'outil de détection (166) pour détecter une quantité de poussée de l'outil de poussée (146) qu'un corps de puce électronique (90) configuré à partir de multiples puces électroniques (92),
un dispositif d'extraction (108) configuré pour extraire de la section de boîtier (111) un élément parmi le corps de puce électronique (90) et la plaque de support (160) ;
le plateau de support (117) configuré pour supporter un élément parmi le corps de puce électronique (90) et la plaque de support (160), extrait de la section de boîtier (111) par le dispositif d'extraction (108) ;
dans lequel
dans le cas où le corps de puce électronique (90) est supporté par le plateau de support (117), la puce électronique (92) est alimentée dans un état où elle est poussée par l'outil de poussée (146), et
dans le cas où la plaque de support (160) est supportée par le plateau de support (117), la quantité de poussée de l'outil de poussée (146) est détectée par l'outil de détection (166).
